Europäisches Patentamt

European Patent Office

Office européen des brevets

(11) Veröffentlichungsnummer: **0 469 186 A1**

# EUROPÄISCHE PATENTANMELDUNG

(21) Anmeldenummer: **90123227.2**

(22) Anmeldetag: **04.12.90**

(51) Int. Cl.⁵: **H05K 7/14**

(30) Priorität: **30.07.90 DE 9011200 U**

(43) Veröffentlichungstag der Anmeldung:
**05.02.92 Patentblatt 92/06**

(84) Benannte Vertragsstaaten:
**BE DE FR GB**

(71) Anmelder: **SIEMENS AKTIENGESELLSCHAFT**
**Wittelsbacherplatz 2**
**W-8000 München 2(DE)**

(72) Erfinder: **Betzler, Hans Ludwig, Dipl.-Ing. (FH)**
**Allgäuerstrasse 57**
**W-8000 München 71(DE)**
Erfinder: **Ouerengässer, Manfred**
**Nockherstrasse 36a**
**W-8000 München 90(DE)**

(54) **Aus einem Leiterplattenpaket bestehende elektrische Baugruppe.**

(57) Als Träger für das Leiterplattenpaket ist eine metallene Grundplatte (1) vorgesehen, welche die Baugruppe räumlich und HF-mäßig in einen oberen und einen unteren Baugruppenraum mit oberen Leiterplatten (2,3) und unteren Leiterplatten (4,5) trennt. Die Leiterplatten (2 bis 5) weisen dasselbe Befestigungsbohrbild wie die Grundplatte (1) auf und sind über Abstandselemente (7a,7b,11,19) an Abstandsbolzen (6) der Grundplatte (1) befestigt. Das Leiterplattenpaket stellt eine kompakte, elektrisch verdrahtete, prüfbare Baugruppe dar. Die Erfindung ist für elektrische Baugruppen allgemein geeignet, z.B. für Leistungsverstärker.

FIG 1

Die Erfindung betrifft eine aus einem Leiterplattenpaket bestehende elektrische Baugruppe mit mindestens zwei Leiterplatten, die über Abstandselemente parallel zueinander und zu einer metallenen Grundplatte an dieser befestigt sind.

Elektrische Geräte, insbesondere der Nachrichtentechnik, enthalten häufig solche aus mehreren parallelen Leiterplatten bestehende Baugruppen. Derartige Baugruppen weisen als Träger für die Leiterplatten eine Grundplatte auf, wobei die parallele Montage und die Positionierung der Leiterplatten an der Grundplatte über Abstandselemente erfolgt. Dabei ist auf eine kompakte sowie montage- und servicefreundliche Bauweise der Baugruppe bei exakter und sicherer Positionierung der Leiterplatten zu achten. In vielen Fällen ist außerdem auch eine HF-mäßige Trennung oder Unterteilung der Baugruppe erforderlich.

Der Erfindung liegt daher die Aufgabe zugrunde, bei einer elektrischen Baugruppe der eingangs genannten Art neben einer vorteilhaften Bauweise auch eine HF-mäßige Trennung der Baugruppe und eine exakte und sichere Positionierung der Leiterplatten zu gewährleisten.

Diese Aufgabe wird bei einer elektrischen Baugruppe gemäß der Erfindung dadurch gelöst, daß die Grundplatte zwischen mindestens einer oberen Leiterplatte und mindestens einer unteren Leiterplatte angeordnet ist und die Baugruppe in einen oberen und einen unteren Baugruppenraum trennt, daß auf der Grundplatte mehrere sowohl in den oberen als auch in den unteren Baugruppenraum hineinragende, mit Gewinden versehene Abstandsbolzen verteilt und mit Sechskantelementen an der Grundplatte befestigt sind, daß sowohl die obere Leiterplatte als auch die untere Leiterplatte an diesen Abstandsbolzen befestigt ist, und daß die Leiterplatten und die Grundplatte mit dem gleichen Befestigungsbohrbild ausgebildet sind.

Bei einer derartigen Baugruppe ist die als Träger des Leiterplattenpaketes dienende Grundplatte zwischen den Leiterplatten vorgesehen und damit so angeordnet, daß sie die Baugruppe räumlich und HF-mäßig in einen oberen und einen unteren Baugruppenraum trennt. Es entstehen somit zwei mechanisch getrennte und elektrisch gegeneinander abgeschirmte Baugruppenräume, wobei die in einem Baugruppenraum angeordneten Leiterplatten jeweils für sich und unabhängig vom anderen Baugruppenraum bei der Montage aufbaubar und für Servicezwecke zugänglich sind. Durch die Befestigung der Leiterplatten an den auf der Grundplatte verteilten Abstandsbolzen wird eine homogene Baugruppe mit kompakter Bauweise und exakter, sicherer Positionierung der Leiterplatten ermöglicht. Außerdem ist bei einer derartigen Bauweise eine aus Grundplatte sowie oberer und unterer Leiterplatte bestehende Baugruppe in einfacher Weise mit zusätzlichen Leiterplatten erweiterbar, da alle Leiterplatten und die Grundplatte mit dem gleichen Befestigungsbohrbild ausgebildet sind.

Vorteilhafte Ausgestaltungen des Gegenstandes des Anspruchs 1 sind in den Unteransprüchen angegeben.

Ein Ausführungsbeispiel einer erfindungsgemäßen elektrischen Baugruppe ist im folgenden anhand der Zeichnung näher beschrieben.

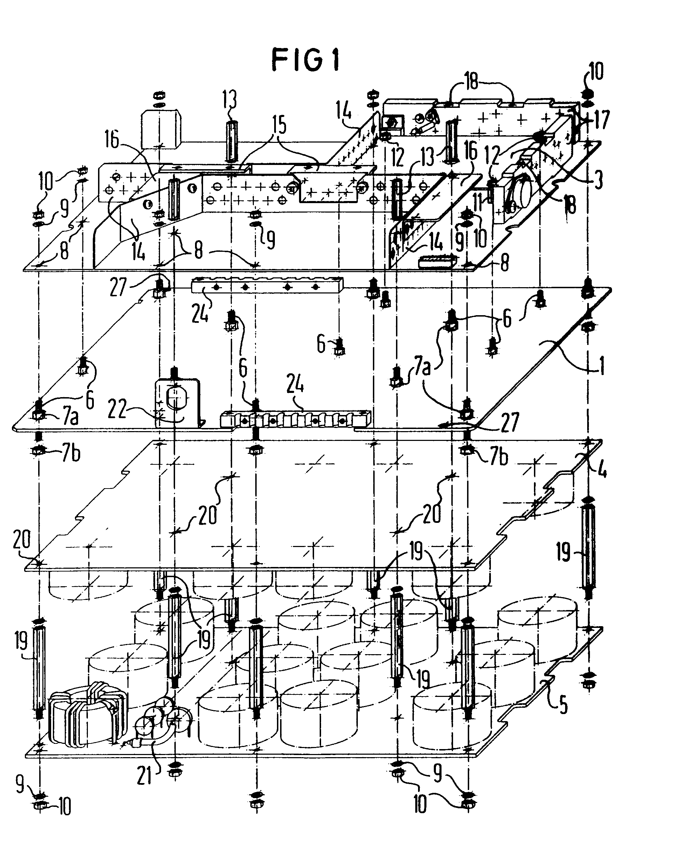

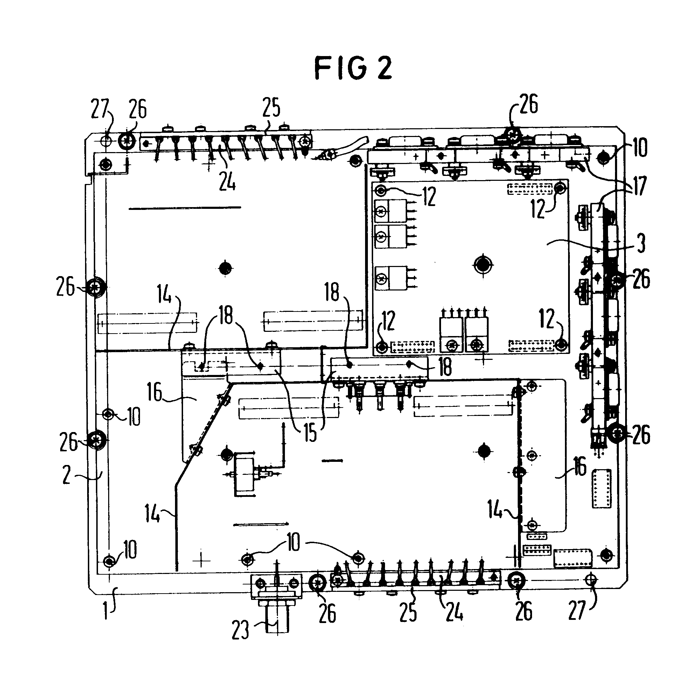

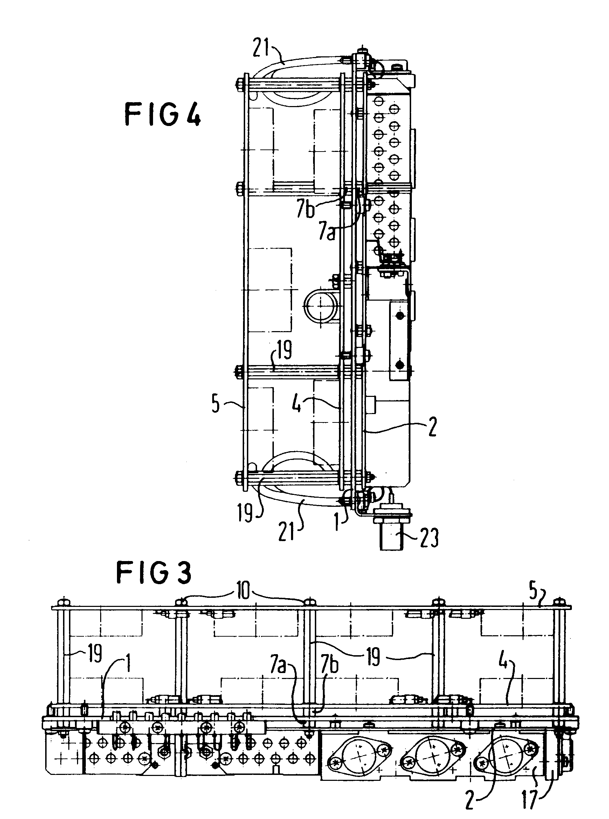

In Fig. 1 ist die aus einem Leiterplattenpaket bestehende elektrische Baugruppe in explosionsartiger Darstellung gezeigt, während in den Fig. 2,3 und 4 die vollständig montierte Baugruppe in drei Ansichten dargestellt ist.

Die elektrische Baugruppe nach den Figuren 1 bis 4 stellt ein sogenanntes Oberwellenfilter eines 1 kW-Leistungsverstärkers dar. Dieses Filter begrenzt im Sendebetrieb die Abstrahlung von Oberwellen. Eine solche Baugruppe besteht im allgemeinen aus mehreren Leiterplatten, wobei die einzelnen mit Spulen und Kondensatoren aufgebauten Filterbereiche HF-mäßig getrennt von einem Steuerungsteil mit Dioden und Transistoren anzuordnen sind. Ferner muß hierbei darauf geachtet werden, daß die Verbindungsleitungen zwischen Steuerungsteil und den Filterbereichen so kurz wie möglich gehalten werden können.

Das hier dargestellte Oberwellenfilter ist eine homogene Baugruppe, deren Leiterplatten in verschiedenen Ebenen wie ein Paket übereinander aufgebaut sind. Dieses Paket wird in hier nicht näher dargestellter Weise als Ganzes in einer Aufnahme montiert und mit einem Deckel verschlossen.

Der Träger des Leiterplattenpaketes ist eine metallene Grundplatte 1, die hier zwischen zwei oberen Leiterplatten 2 und 3 und zwei unteren Leiterplatten 4 und 5 angeordnet ist. Damit ist die Baugruppe räumlich und HF-mäßig in einen oberen und in einen unteren Baugruppenraum getrennt, d.h. die auf den unteren Leiterplatten 4 und 5 untergebrachten Filterbereiche (Spulen und Kondensatoren) sind von dem auf den oberen Leiterplatten 2 und 3 vorgesehenen Steuerungsteil (Relaisschaltungen, Dioden, Transistoren) mechanisch getrennt und elektrisch gegeneinander abgeschirmt. Die Leiterplatten 2,4 und 5 haben die gleichen Außenabmessungen und - wie auch die mit einer Teilbaugruppe ausgebildete, wesentlich kleinere und auf der oberen Leiterplatte 2 montierte zusätzliche Leiterplatte 3 - das gleiche Befestigungsbohrbild wie die Grundplatte 1. Auf der Grundplatte sind - überwiegend in den Randbereichen, aber auch innerhalb der Fläche der Grundplatte verteilt - mehrere Abstandsbolzen 6 angeordnet. Diese Abstandsbolzen sind hier aus einem Sechskantbolzen hergestellt, der so bearbeitet ist, daß die in den oberen und in den unteren Baugruppenraum hineinragenden Enden ein Gewinde aufweisen und dazwischen ein Sechskantelement 7a stehenbleibt. Die Abstandsbolzen 6 sind an der Unterseite der Grundplatte mit als Muttern 7b ausgebildeten Sechskantelementen an der Grundplatte befestigt. An diesen Abstandsbolzen 6 sind die oberen Leiterplatten 2 und 3 und die unteren Leiterplatten 4 und 5 befestigt, wobei die Sechskantelemente 7a und 7b durch eine entsprechende Bemessung gleichzeitig als Abstandselemente zwischen der Grundplatte 1 und der ihr jeweils am nächsten liegenden oberen Leiterplatte 2 bzw. der unteren Leiterplatte 4 dienen.

Auf der Oberseite der Grundplatte 1 wird die hier ein Steuerungsteil bildende Leiterplatte 2 montiert, wobei diese Leiterplatte mit den im Befestigungsbohrbild der Grundplatte angeordneten und damit der Anordnung der Abstandsbolzen 6 entsprechenden Löchern 8 auf die Abstandsbolzen aufgesteckt und unter Zwischenfügung von Unterlegscheiben 9 mittels Muttern 10 an den Abstandsbolzen befestigt wird. Auch die auf der Leiterplatte 2 montierte zusätzliche Leiterplatte 3 weist im Befestigungsbohrbild der Grundplatte angeordnete Löcher auf und ist über z.B. vier säulenartige, zwischen ihr und der Leiterplatte 2 eingesetzte und mit einem Innengewinde an einem Ende sowie einem Gewindebolzen am anderen Ende ausgebildete sechskantige Abstandselemente 11 sowie über auf deren Gewindebolzen aufschraubbare, den Muttern 10 entsprechende Muttern 12 an der Grundplatte 1 befestigt. Außerdem sind an der oberen Leiterplatte 2 noch vier weitere säulenartige, sechskantige Abstandsbolzen 13 vorgesehen, die an beiden Enden mit einem Innengewinde versehen sind, zur Befestigung eines Deckels dienen und ebenfalls auf Abstandsbolzen 6 der Grundplatte 1 aufgeschraubt sind. Die obere Leiterplatte 2 ist elektrisch in verschiedene Bereiche unterteilt. Zur Abschirmung dieser Bereiche gegeneinander sind verschieden ausgeformte metallene Trennwände 14 eingeschwallt. Daran sind Winkelbleche 15 mit wärmeerzeugenden elektrischen Bauelementen, z.B. mit Dioden, montiert. Außerdem sind an den Trennwänden 14 zwei zusätzliche, als Griffe ausgeformte Winkelbleche 16 befestigt, mit denen die ganze Baugruppe beim Ein- und Ausbau gehalten werden kann. Am Rande der oberen Leiterplatte 2 sind zwei vorgefertigte Teilbaugruppen, bestehend aus Aluminiumklötzen 17 und beidseitig daran befestigten Transistoren, montiert. An der Oberseite der Klötze sind - ebenso wie an den Winkelblechen 15 für die elektrischen Bauelemente - Gewindebohrungen 18 vorgesehen, in denen später der mit Prägungen versehene, hier nicht näher dargestellte Deckel zusätzlich befestigt wird, um eine verbesserte Wärmeableitung zu erzielen.

Auf der Unterseite der Grundplatte 1 wird die erste untere Leiterplatte 4 des Filterbereiches mit langen, säulenartigen, sechskantigen Abstandselementen 19 montiert, die an einem Ende ein Innengewinde und am anderen Ende einen Gewindebolzen aufweisen. Die Abstandsbolzen 6 der Grundplatte 1 durchdringen im Befestigungsbohrbild der Grundplatte angeordnete Löcher 20 der Leiterplatte 4 und werden mit den Abstandselementen 19 verschraubt. Die zweite untere Leiterplatte 5 kann - mit ihrer Bauelementeseite der Bauelementeseite der Leiterplatte 4 zugewandt - aufgrund des übereinstimmenden Befestigungsbohrbildes auf die Gewindebolzen der säulenartigen Abstandselemente 19 aufgesteckt und unter Zwischenfügung von Unterlegscheiben 9 wieder mit Muttern 10 befestigt werden. Die zur Verfügung stehende gemeinsame Bauelementehöhe (= Höhe der säulenartigen Abstandselemente 19) wird optimal ausgenutzt, indem einem niedrigen Bauelementebereich der einen Leiterplatte, z.B. der Leiterplatte 4, hohe Bauelemente der anderen Leiterplatte, z.B. der Leiterplatte 5, gegenüberstehend angeordnet werden. Die Höhe des Leiterplattenpaketes wird somit auf ein Minimum reduziert.

Bei der dargestellten Baugruppe werden aus dem unteren Baugruppenraum mit den Leiterplatten 4 und 5 HF-Leitungen 21 nach oben in den oberen Baugruppenraum mit den Leiterplatten 2 und 3 geführt. Hierzu ist die Grundplatte 1 mindestens an einer Längsseite mit einem Haltewinkel 22 für einen HF-Stecker 23 (Eingangssignal) sowie an beiden Längsseiten mit schräg einander gegenüberliegenden und kammartig ausgebildeten Halteelementen 24 versehen, in welche die HF-Leitungen 21 mittels Abdeckleisten 25 eingespannt werden können. Die Innenleiter des HF-Leitungen werden elektrisch an die Leiterplatte 2 angeschlossen. Das dargestellte Leiterplattenpaket nach den Fig. 2 bis 4 stellt somit eine kompakte, elektrisch verdrahtete, prüfbare Einheit dar.

Zur Befestigung der Baugruppe in einer hier nicht dargestellten Aufnahme weist die Grundplatte 1 an den Längs- und Querseiten noch jeweils zwei am Plattenrand in eingepreßten Buchsen unverlierbar montierte Halsschrauben 26 auf. Außerdem ist die Grundplatte 1 an zwei einander diagonal gegenüberliegenden Ecken noch mit Führungsbohrungen 27 versehen, welche im Zusammenwirken mit Führungselementen der Aufnahme das Einführen und die lagerichtige Zuordnung der Baugruppe erleichtern. Die lagerichtige Zuordnung wird dadurch erreicht, daß die Führungsbohrungen 27 ungleiche Abstände zum linken bzw. rechten Plattenrand haben (Fig.2).

Die dargestellte Baugruppe stellt eine raumsparende, kompakte Einheit dar, die mit wenigen verschiedenen mechanischen Teilen (Mehrfachverwendung von Abstandselementen, Normteilen) kostengünstig aufgebaut ist.

**Patentansprüche**

1. Aus einem Leiterplattenpaket bestehende elektrische Baugruppe, mit mindestens zwei Leiterplatten, die über Abstandselemente parallel zueinander und zu einer metallenen Grundplatte an dieser befestigt sind,
dadurch gekennzeichnet, daß die Grundplatte (1) zwischen mindestens einer oberen Leiterplatte (2,3) und mindestens einer unteren Leiterplatte (4,5) angeordnet ist und die Baugruppe in einen oberen und einen unteren Baugruppenraum trennt,
daß auf der Grundplatte (1) mehrere sowohl in den oberen als auch in den unteren Baugruppenraum hineinragende, mit Gewinden versehene Abstandsbolzen (6) verteilt und mit Sechskantelementen (7a,7b) an der Grundplatte befestigt sind, daß sowohl die obere Leiterplatte (2,3) als auch die untere Leiterplatte (4,5) an diesen Abstandsbolzen (6) befestigt ist, und daß die Leiterplatten (2 bis 5) und die Grundplatte (1) mit dem gleichen Befestigungsbohrbild ausgebildet sind.

2. Elektrische Baugruppe nach Anspruch 1,
dadurch gekennzeichnet, daß die Grundplatte (1) zu ihrer und der Baugruppe Befestigung in einer Aufnahme an den Längs- und Querseiten jeweils zwei am Plattenrand in eingepreßten Buchsen unverlierbar montierte Halsschrauben (26) aufweist.

3. Elektrische Baugruppe nach Anspruch 1 oder 2,
dadurch gekennzeichnet, daß an den beiden Längsseiten der Grundplatte (1) kammartig ausgebildete Halteelemente (24) für von dem einen in den anderen Baugruppenraum führbare HF-Leitungen vorgesehen sind.

4. Elektrische Baugruppe nach einem der Ansprüche 1 bis 3,
dadurch gekennzeichnet, daß die Grundplatte (1) mindestens an einer Längsseite mit einem Haltewinkel (22) für einen HF-Stecker (23) ausgebildet ist.

5. Elektrische Baugruppe nach einem der vorhergehenden Ansprüche,
dadurch gekennzeichnet, daß die zur Befestigung der Abstandsbolzen (6) an der Grundplatte (1) dienenden Sechskantelemente (7a,7b) als Abstandselemente zwischen der Grundplatte (1) und der ihr jeweils am nächsten liegenden oberen bzw. unteren Leiterplatte (2 bzw. 4) ausgebildet sind.

6. Elektrische Baugruppe nach einem der vorhergehenden Ansprüche,
dadurch gekennzeichnet, daß eine weitere obere und untere Leiterplatte (3 bzw. 5) jeweils über säulenartige, zwischen ihr und der der Grundplatte (1) am nächsten liegenden oberen bzw. unteren Leiterplatte (2 bzw. 4) eingesetzte und mit einem Innengewinde an einem Ende sowie einem Gewindebolzen am anderen Ende ausgebildete Abstandselemente (11 bzw. 19) an den Abstandsbolzen (6) der Grundplatte (1) gehalten und über auf die Gewindebolzen der säulenartigen Abstandselemente (11,19) aufschraubbare Muttern (12) befestigt sind.

7. Elektrische Baugruppe nach einem der vorhergehenden Ansprüche,
dadurch gekennzeichnet, daß bei zwei unteren Leiterplatten (4,5) diese mit ihren Bauelementeseiten einander zugewandt angeordnet sind.

8. Elektrische Baugruppe nach einem der vorhergehenden Ansprüche,
dadurch gekennzeichnet, daß die obere Leiterplatte (2) mit verschieden ausgeformten metallenen Trennwänden (14) versehen ist.

9. Elektrische Baugruppe nach Anspruch 8,
dadurch gekennzeichnet, daß an der oberen Leiterplatte (2) Klötze (17) und Winkelbleche (15) für wärmeerzeugende elektrische Bauelemente vorgesehen sind.

10. Elektrische Baugruppe nach Anspruch 9,
dadurch gekennzeichnet, daß die Winkelbleche (15) für die elektrischen Bauelemente und weitere, als Griffe ausgeformte Winkelbleche (16) an den Trennwänden (14) befestigt sind.

11. Elektrische Baugruppe nach Anspruch 9 oder 10,
dadurch gekennzeichnet, daß die Winkelbleche (15) und die Klötze (17) für die elektrischen Bauelemente mit Gewindebohrungen (18) für die Befestigung eines Baugruppendeckels versehen sind.

12. Elektrische Baugruppe nach einem der vorhergehenden Ansprüche, dadurch gekennzeichnet, daß an der der Grundplatte (1) am nächsten liegenden oberen Leiterplatte (2) zur Befestigung eines Deckels säulenartige, sechskantige und an beiden Enden mit einem Innengewinde versehene Abstandsbolzen (13) vorgesehen und mit den Abstandsbolzen (6) der Grundplatte (1) verschraubt sind.

# FIG 1

# FIG 2

FIG 4

FIG 3

## EINSCHLÄGIGE DOKUMENTE

| Kategorie | Kennzeichnung des Dokuments mit Angabe, soweit erforderlich, der maßgeblichen Teile | Betrifft Anspruch | KLASSIFIKATION DER ANMELDUNG (Int. Cl.5) |
|---|---|---|---|
| A | DE-U-8 505 220 (BROWN BOVERY & CIE AG) <br> * Seite 7, Zeile 22 - Zeile 35; Abbildung 1 * <br> --- | 1 | H05K7/14 |
| A | DE-U-8 422 203 (SIEMENS AG) <br> * Seite 6, Zeile 18 - Zeile 23; Abbildung 1 * <br> --- | 1 | |
| A | US-A-4 650 973 (PIKE) <br> * Abbildung 1 * <br> ----- | 1 | |
| | | | **RECHERCHIERTE SACHGEBIETE (Int. Cl.5)** <br><br> H05K |

Der vorliegende Recherchenbericht wurde für alle Patentansprüche erstellt

| Recherchenort | Abschlußdatum der Recherche | Prüfer |
|---|---|---|
| DEN HAAG | 22 NOVEMBER 1991 | RUBENOWITZ A. |